# EUROPÄISCHE PATENTSCHRIFT

(11) **EP 0 389 954 B1**
(45) Veröffentlichungstag und Bekanntmachung des Hinweises auf die Patenterteilung: **08.09.1993**
(21) Anmeldenummer: 90105378.5
(22) Anmeldetag: 21.03.1990
(51) Int. Cl.: H05K 7/14

(54) **Vorrichtung zum Führen und Halten von Leiterplatten**
Device for guiding and holding a circuit board
Dispositif pour guider et tenir un circuit imprimé

(30) Priorität: 31.03.1989 DE 8903958 U
(43) Veröffentlichungstag der Anmeldung: 03.10.1990
(73) Patentinhaber: Siemens Nixdorf Informationssysteme Aktiengesellschaft, 33102 Paderborn (DE)
(72) Erfinder: Stickel, Heinz, Dipl.-Ing. (FH), D-8038 Gröbenzell (DE); Reihl, Peter, Dipl.-Ing. (FH), D-8000 München 60 (DE)
(74) Vertreter: Fuchs, Franz-Josef, Dr.-Ing.

(56) Entgegenhaltungen:
- DE-A- 3 624 839
- DE-B- 2 554 106
- DE-U- 8 812 060
- GB-A- 1 162 281

## Beschreibung

Die Erfindung betrifft eine Vorrichtung zum Führen und Halten von an gegenüberliegenden Kanten geführten Leiterplatten gemäß den Merkmalen des Oberbegriffs des Anspruchs 1.

Beim Einbau von Leiterplatten tritt immer wieder das Problem auf, daß die Leiterplatten sehr großen Längen- und Dickenschwankungen unterworfen sind. Bei der Verwendung von herkömmlichen Leiterplatten-Führungsschienen kann es vorkommen, daß die Leiterplatten bei Längenuntermaß keinen Halt mehr haben oder bei Längenübermaß unter Spannung eingebaut werden und sich durchwölben. Sind die Leiterplatten zu dünn, können sie in den Führungsschienen klappern und sind sie zu dick, klemmen sie darin fest.

Für den Dickenausgleich von Leiterplatten ist aus der deutschen Gebrauchsmusteranmeldung G 88 12060.0 eine Vorrichtung zum Führen und Halten von Leiterplatten bekannt geworden, die aus einer U-förmigen Schiene mit zwei in der Nähe der beiden Schienenenden angeordneten, quer zu den Schenkein nach außen weisenden Halteelementen besteht, an dessen einem Schenkel mindestens zwei ins Innere der U-förmigen Schiene ragende Andruckelement für die Leiterplatten ausgebildet sind. Mit dieser bekannten Vorrichtung lassen sich zwar die Dickenschwankungen der Leiterplatten ausgleichen, nicht aber deren Längenschwankungen.

Aufgabe der Erfindung ist es deshalb, eine Vorrichtung zum Führen und Halten von an gegenüberliegenden Kanten geführten Leiterplatten anzugeben, die die Dickenschwankungen von Dicken-und Längenschwankungen unterworfenen Leiterplatten ausgleicht und so weitergebildet werden kann, daß sie auch die Längenschwankungen ausgleichen kann.

Diese Aufgabe wird bei einer Vorrichtung der eingangs genannten Art erfindungsgemäß durch die im kennzeichnenden Teil des Anspruchs 1 angegebenen Merkmale gelöst. Durch diese einfachen Maßnahmen erhält man eine Leiterplattenführungsschiene mit variabler Spaltbreite, so daß die Dickenschwankungen von Leiterplatten ausgeglichen werden können. Außerdem wird durch die Tatsache, daß in Gegenrichtung der Schenkel nach außen weisende Halteelemente verwendet werden, die Möglichkeit eröffnet, daß auch Längenschwankungen der Leiterplatten ausgeglichen werden können.

Vorteilhafte Ausgestaltungen der Erfindung sind Gegenstand von Unteransprüchen, insbesondere des Anspruchs 10, mit dem die Längenschwankungen von Leiterplatten ausgeglichen werden können.

Durch die stiftartige Ausgestaltung der Halteelemente kann die Vorrichtung durch Eindrücken in Bohrungen eines entsprechenden Montageteils leicht montiert werden. Dabei halten gegebenenfalls Federelemente die Vorrichtung zum Montageteil federnd auf Abstand.

Die an den freien Enden der Halteelemente vorgesehenen Rastelemente verhindern ein Herausfallen aus den zugehörigen Bohrungen des Montageteils. Die Rastelemente können dabei verschieden ausgestaltet sein. Ein sicherer Halt der Halteelemente in den zugehörigen Bohrungen wird insbesondere dadurch erzielt, daß die Halteelemente jeweils paarweise angeordnet auftreten, wobei deren Rastelemente jeweils nur einseitig, und zwar jeweils auf voneinander wegweisenden Seiten, ausgebildet sind. Dies wird dadurch erzielt, daß die Halteelemente nur jeweils aus einer Teilkörperhälfte bestehen. Die Halteelemente wirken dadurch wie Spreizbacken.

Durch Anschrägen der seitlichen Kanten an den freien Enden der als Teilkörperhälften ausgebildeten Halteelemente wird das Einführverhalten der Halteelemente in die zugehörigen Bohrungen verbessert.

Die Ausbildung der Federelemente als Federzungen ermöglicht die einstückige Herstellung der Vorrichtung. Die Vorrichtung läßt sich deshalb auch besonders leicht als Kunststoffteil fertigen. Als Kunststoffteil weist die Vorrichtung zudem gute federnde Eigenschaften der federnden Teile und gute gleitende Eigenschaften der führenden Teile auf.

Nachfolgend wird ein Ausführungsbeispiel der Erfindung anhand der Zeichnung näher erläutert.
Es zeigen:
- FIG 1: Eine Vorderansicht der Vorrichtung gemäß der Erfindung,
- FIG 2: eine Seitenansicht der Vorrichtung nach FIG 1 im Schnitt längs der Linie II-II und
- FIG 3: eine Halteelement der Vorrichtung nach FIG 2 als Detaildarstellung.

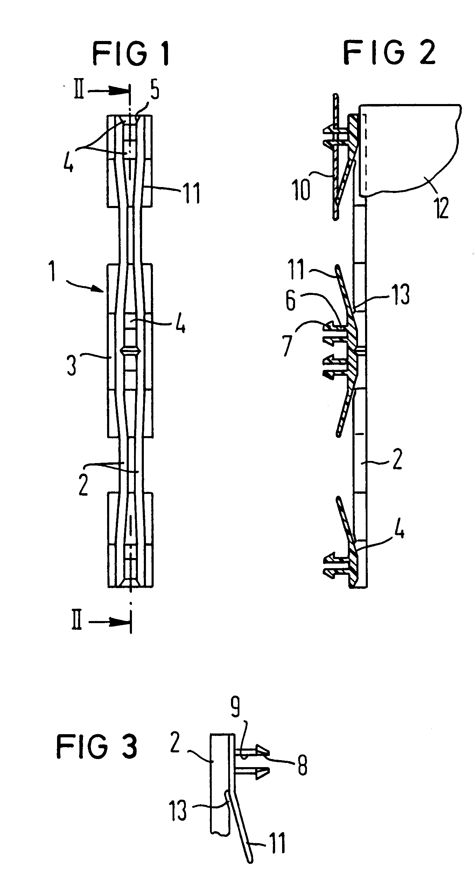

Die FIG 1 bis FIG 3 zeigen eine Vorrichtung zum Führen und Halten von Leiterplatten, die sowohl Dicken- als auch Längenschwankungen der Leiterplatten ausgleicht. Wie insbesondere der FIG 1 zu entnehmen ist, besteht die Vorrichtung aus zwei parallel verlaufenden Schienenteilen, die im folgenden als Schenkel 2 bezeichnet werden. Die Schenkel 2 sind längs des Schienenverlaufs zueinander gegensinnig gewellt. Der zwischen den Schenkeln 2 gebildete Spalt weist Verbreiterungen und Verengungen auf. Stellen, an denen der Spalt verbreitert ist, bilden einen Wellenbauch. Der Abstand der Schenkel 2 voneinander ist so gewählt, daß die Spaltbreite an verengten Stellen geringfügig kleiner ist als die kleinste Dicke der verwendeten Leiterplatten. An Stellen, die verbreitert sind, ist die Spaltbreite so gewählt, daß sie geringfügig größer ist als die größte Dicke der verwendeten Leiterplatten. Die mittels der beiden Schenkeln 2 gebildeten Schiene 1 ist so gestaltet, daß an den beiden Schienenenden jeweils ein Wellenbauch auftritt.

Die Schenkel 2 sind an Bereichen, an denen ein Wellenbauch auftritt, durch Verbindungsstege 3 miteinander verbunden. Wenigstens an diesen Stellen weist die Vorrichtung die Form einer U-förmigen Schiene 1 auf, weswegen die eingangs angesprochenen Schienenteile als Schenkel 2 aufgefaßt werden.

Wird von den Enden der Schiene 1 her eine Leiterplatte zwischen den Schenkeln 2 eingeschoben, klemmen die Schenkel 2 an verengten Stellen die Leiterplatte ein. Dadurch, daß an den verengten Stellen keine Verbindungsstege 3 vorgesehen sind, sind die Schenkel 2 an diesen Stellen frei beweglich und können somit als federnde Andruckelemente wirken. Auf diese Weise passen sich die Schenkel 2 den jeweiligen Dicken der Leiterplatten an, und halten diese stets spielfrei fest.

Damit die Leiterplatten beim Einschieben in den von den Schenkeln 2 gebildeten Spalt nicht an den zur Schieberichtung querstehenden Kanten hängenbleiben, weisen die quer zu den Schenkeln 2 verlaufenden Innenkanten der Verbindungsstege 3 Anlaufschrägen 4 auf. Zusätzlich sind an den Schienenenden die Innenkanten der Schenkel 2 mit Einführschrägen 5 versehen, so daß der Spalt für die Leiterplatte mit einer trichterähnlichen Öffnung beginnt.

Wie in FIG 2 zu sehen ist, weisen die Verbindungsstege 3 in Richtung der Schenkel 2 nach außen gerichtete Halteelemente 6 auf. Die Halteelemente 6 sind als Stifte mit als Rastelement 7 geformten freien Enden ausgebildet. Die Halteelemente 6 weisen im wesentlichen die Form eines Zylinders auf. Das Rastelement 7 wird durch einen Kegel gebildet, der auf den Zylinder aufgesetzt ist. Dabei ist die Grundfläche des Kegels größer gewählt als die Deckfläche des Zylinders, so daß sich ein zunächst überstehender und dann verjüngender Bereich ergibt. Im Ausführungsbeispiel ist der verwendete Kegel zusätzlich abgeplattet. Anstelle des Kegels könnte auch eine Kugel bzw. eine Teilkugel, speziell eine Halbkugel mit jeweils entsprechendem Übermaß auf den Zylinder aufgesetzt sein.

Die im Ausführungsbeispiel verwendeten Halteelemente 6 bestehen nur aus einer Teilkörperhälfte des eben beschriebenen Stiftkörpers. Die hierdurch entstehenden seitlichen Kanten 8 an den Körperinnenflächen 9 (jeweils FIG 3) im Bereich der freien Enden sind angeschrägt.

FIG 2 zeigt, daß die Halteelemente 6 auf den Verbindungsstegen 3 jeweils paarweise mit einem Abstand voneinander angeordnet sind. Die Halteelemente 6 sind dabei so ausgerichtet, daß die Rastelemente 7 jeweils voneinander weg zeigen. Auf diese Weise wirken die Halteelemente 6 wie Spreizbacken, die beim Einführen in eine Bohrung kurzzeitig zusammengedrückt werden und sich dann nach dem Hindurchgreifen durch die Bohrung verspreizen. Beim Versuch, die Halteelemente 6 aus den Bohrungen herauszuziehen, verhaken sich die Rastelemente 7 sicher an den Rändern der Bohrungen.

Im Ausführungsbeispiel sind die Verbindungsstege 3 zwischen den Enden der Schiene 1 doppelt so lang ausgebildet als an den Enden selbst. Sie weisen deshalb auch doppelt soviele Halteelemente 6 als die Verbindungsstege 3 an den Schienenenden auf. Dies rührt daher, daß die gezeigte Vorrichtung spiegelsymmetrisch zu ihrer Querachse ausgebildet ist. Eine Hälfte der Vorrichtung kann deshalb als Grundelement für weitere Vorrichtungen angesehen werden, die durch Aneinanderreihung mehrer solcher Grundelemente entstehen.

An den quer zu den Schenkeln 2 verlaufenden Kanten der Verbindungsstege 3 sind Federzungen 11 befestigt. Die Federzungen 11 sind auf Seiten der Halteelemente 6 schräg angeordnet. Die Schräge und die Länge der Federzungen 11 sind so gewählt, daß sich die Schiene 1 von dem Montageteil 10 (FIG 2) soweit abdrückt, daß sich die Rastelemente 7 der Halteelemente 6 unter Federdruck an den Rändern der jeweils zugehörigen Bohrungen verhaken.

Beim Einschieben einer Leiterplatte 12 in den Spalt zwischen den Schenkeln 2 wird die Schiene 1 in Abhängigkeit von den Längenschwankungen der Leiterplatte 12 gegen die Kraft der Federzungen 11 an das Montageteil 10 gedrückt, wodurch die Halteelemente 6 weiter durch die Bohrungen des Montageteils hindurchgreifen.

Beim Andrücken der Schiene 1 an das Montageteil 10 werden die Federzungen 11 gebogen. Um die Elastizität und die Wirkung der Federzungen 11 zu erhöhen, sind in den Einspannbereichen der Federzungen 11 jeweils über die den Schenkeln 2 zugewandten Kantenverläufen sich in die Schenkel 2 erstreckende Einkerbungen 13 vorgesehen.

Gemäß dem Ausführungsbeispiel sind an den zu den Schienenenden weisenden Kanten der den Enden der Schiene 1 zugeordneten Verbindungsstege 3 die Federzungen 11 eingespart.

## Patentansprüche

1. Vorrichtung zum Führen und Halten von an gegenüberliegenden Kanten geführten Leiterplatten, bestehend aus einer im wesentlichen U-förmigen Schiene mit Halteelementen und mit einem im Vergleich zur Dicke der Leiterplatte etwas größeren Schenkelabstand und wenigstens einem derart ausgebildeten Schenkel, daß sich wenigstens an einer Stelle ein die Dicke der Leiterplatte unterschreitender Schenkelabstand ergibt,
**dadurch gekennzeichnet,** daß die Schenkel (2) in Richtung der Schiene (1) gegensinnig zueinander gewellt sind, daß an den Enden der Schiene (1) jeweils ein Wellenbauch ausgebildet ist und daß an den Enden der Schiene (1) und an wenigstens einem dazwischenliegenden Wellenbauch jeweils Verbindungsstege (3) mit in Gegenrichtung der Schenkel (2) nach außen weisenden Halteelementen (6) vorgesehen sind.

2. Vorrichtung nach Anspruch 1,
**dadurch gekennzeichnet,** daß die Verbindungsstege (3) an den quer zu den Schenkeln (2) verlaufenden Innenkanten mit Anlaufschrägen (4) versehen sind.

3. Vorrichtung nach Anspruch 1 oder 2,
**dadurch gekennzeichnet,** daß an den Schienenenden an den Innenkanten der Schenkel (2) Einführschrägen (5) ausgebildet sind.

4. Vorrichtung nach einem der vorherigen Ansprüche,
**dadurch gekennzeichnet,** daß die Halteelemente (6) als Stifte ausgebildet sind, deren freien Enden wenigstens ein Rastelement (7) aufweisen.

5. Vorrichtung nach Anspruch 4,
**dadurch gekennzeichnet,** daß die Stifte im wesentlichen eine zylindrische Form und am freien Ende einen zuerst vorspringenden und anschließend sich verjüngenden Ansatz aufweisen.

6. Vorrichtung nach Anspruch 5,
**dadurch gekennzeichnet,** daß der Ansatz kegelförmig ausgebildet ist.

7. Vorrichtung nach Anspruch 5,
**dadurch gekennzeichnet,** daß der Ansatz kugelförmig ausgebildet ist.

8. Vorrichtung nach einem der Ansprüche 4 bis 7,
**dadurch gekennzeichnet,** daß die Stifte mindestens aus einer Teilkörperhälfte bestehen.

9. Vorrichtung nach Anspruch 8,
**dadurch gekennzeichnet,** daß die Teilkörperhälften im Bereich der freien Enden seitlich angeschrägt sind.

10. Vorrichtung nach Anspruch 9,
**dadurch gekennzeichnet,** daß die Teilkörperhälften im Abstand zueinander mit jeweils aufeinander zuweisenden Körperinnenflächen (9) paarweise angeordnet sind.

11. Vorrichtung nach einem der vorherigen Ansprüche,
**dadurch gekennzeichnet,** daß die Halteelemente (6) in der Weise ein Übermaß aufweisen, daß die Vorrichtung parallel zur Schenkelrichtung verschiebbar ist und daß auf Seiten der Halteelemente (6) jeweils in Wirkverbindung mit den Halteelementen (6) stehende Federelemente vorgesehen sind, die eine das Übermaß ausgleichende Federwirkung aufweisen.

12. Vorrichtung nach Anspruch 11,
**dadurch gekennzeichnet,** daß die Federelemente durch schräg von den quer zu den Schenkeln (2) verlaufenden Kanten der Verbindungsstege (3) abstehende Federzungen (11) gebildet sind.

13. Vorrichtung nach Anspruch 12,
**dadurch gekennzeichnet,** daß in den Einspannbereichen der Federzungen (11) jeweils über die den Schenkeln (2) zugewandten Kantenverläufen sich in die Schenkel (2) erstreckende Einkerbungen (13) vorgesehen sind.

14. Vorrichtung nach einem der vorherigen Ansprüche,
**gekennzeichnet durch** die Ausbildung als Kunststoffteil.

## Claims

1. Device for guiding and holding printed-circuit boards which are guided on opposite edges, comprising an essentially U-shaped rail having holding elements and having a limb separation which is somewhat larger than the thickness of the printed-circuit board, and having at least one limb which is constructed in such a manner that a limb separation, which is less than the thickness of the printed-circuit board, is produced at at least one point, characterised in that the limbs (2) are corrugated in opposite senses with respect to one another in the direction of the rail (1), in that in each case one corrugation bulge is constructed at the ends of the rail (1), and in that connecting webs (3) having holding elements (6) which point outwards in the opposite direction to the limbs (2) are in each case provided at the ends of the rail (1) and on at least one intermediately located corrugation bulge.

2. Device according to Claim 1, characterised in that the connecting webs (3) are provided on the inner edges running transversely with respect to the limbs (2) with lead-in inclines (4).

3. Device according to Claim 1 or 2, characterised in that insertion inclines (5) are constructed on the rail ends, on the inner edges of the limbs (2).

4. Device according to one of the preceding claims, characterised in that the holding elements (6) are constructed as pins whose free ends have at least one latching element (7).

5. Device according to Claim 4, characterised in that the pins essentially have a cylindrical shape and, at the free end, have an attachment which initially projects and subsequently tapers.

6. Device according to Claim 5, characterised in that the attachment is constructed in the form of a cone.

7. Device according to Claim 5, characterised in that the attachment is constructed in the form of a sphere.

8. Device according to one of Claims 4 to 7, characterised in that the pins comprise at least one partial-body half.

9. Device according to Claim 8, characterised in that the partial-body halves are inclined laterally in the region of the free ends.

10. Device according to Claim 9, characterised in that the partial-body halves are arranged in pairs at a distance from one another, having mutually facing body inner surfaces (9) in each case.

11. Device according to one of the preceding claims, characterised in that the holding elements (6) are oversize in such a manner that the device can be displaced parallel to the limb direction, and in that spring elements which in each case are effectively connected to the holding elements (6) and have a spring effect which compensates for the oversize are provided on the aides of the holding elements (6).

12. Device according to Claim 11, characterised in that the spring elements are formed by means of spring tongues (11) which project obliquely from the edges of the connecting webs (3) which run transversely with respect to the limbs (2).

13. Device according to Claim 12, characterised in that notches (13), which in each case extend over the courses of the edges facing the limbs (2) into the limbs (2), are provided in the clamping-in regions of the spring tongues (11).

14. Device according to one of the preceding claims, characterised by construction as a plastic part.

## Revendications

1. Dispositif pour guider et retenir des plaquettes à circuits imprimés guidées le long de bords opposés, constitué par un rail sensiblement en forme de U comportant des éléments de retenue et dont la distance entre les branches est légèrement supérieure à l'épaisseur de la plaquette à circuits imprimés, et dont au moins une branche est agencée de telle sorte qu'au moins en un emplacement, on obtient une distance entre les branches qui est inférieure à l'épaisseur de la plaquette à circuits imprimés,
caractérisé par le fait que les branches (2) sont ondulées dans des sens réciproquement opposés en direction du rail (1), qu'un ventre d'ondulation est formé respectivement sur les extrémités du rail (1) et qu'au niveau des extrémités du rail (1) et d'au moins un ventre d'ondulation intermédiaire, il est prévu respectivement des barrettes de liaison (3) comportant des éléments de retenue (6) qui sont dirigés vers l'extérieur, à l'opposé de la branche (2).

2. Dispositif suivant la revendication 1,
caractérisé par le fait que les barrettes de liaison (3) comportent des rampes (4) au niveau des bords intérieurs qui s'étendent transversalement par rapport aux branches (2).

3. Dispositif suivant la revendication 1 ou 2, caractérisé par le fait que des rampes d'insertion (5) sont formés sur les extrémités du rail, au niveau des bords intérieurs des branches (2).

4. Dispositif suivant l'une des revendications précédentes, caractérisé par le fait que les éléments de retenue (6) sont réalisés sous la forme de tiges, dont les extrémités libres possèdent au moins un élément d'encliquetage (7).

5. Dispositif suivant la revendication 4, caractérisé par le fait que les tiges possèdent essentiellement une forme cylindrique et comportent, au niveau de l'extrémité libre, un appendice tout d'abord saillant, qui se rétrécit ensuite.

6. Dispositif suivant la revendication 5, caractérisé par le fait que l'appendice saillant est réalisé avec une forme conique.

7. Dispositif suivant la revendication 5, caractérisé par le fait que l'appendice saillant possède une forme sphérique.

8. Dispositif suivant l'une des revendications 4 à 7, caractérisé par le fait que les tiges sont constituées au moins par une moitié de corps.

9. Dispositif suivant la revendication 8, caractérisé par le fait que les moitiés de corps sont biseautées latéralement au niveau des extrémités libres.

10. Dispositif suivant la revendication 9, caractérisé par le fait que les moitiés de corps sont disposées par couples, à distance les unes des autres, de telle sorte que des surfaces intérieures respectives (9) du corps sont situées en vis-à-vis.

11. Dispositif suivant l'une des revendications précédentes, caractérisé par le fait que les éléments de retenue (6) possèdent une surcote de telle sorte que le dispositif peut être déplacé parallèlement à la direction des branches et que des deux côtés des éléments de retenue (6), il est prévu des éléments élastiques, qui sont reliés selon une liaison active aux éléments de retenue (6) et possèdent une action élastique qui compense la surcote.

12. Dispositif suivant la revendication 11, caractérisé par le fait que les éléments élastiques sont formés par des languettes élastiques (11), qui font saillie obliquement à partir des bords des barrettes de liaison (3), qui s'étendent transversalement par rapport aux branches (2).

13. Dispositif suivant la revendication 12, caractérisé par le fait qu'il est prévu des encoches (13), qui s'étendent dans les branches (2), respectivement sur les parties des bords tournées vers ces branches, dans les zones d'encastrement des languettes élastiques (11).

14. Dispositif suivant l'une des revendications précédentes, caractérisé par sa réalisation sous la forme d'une pièce en matière plastique.
